# EUROPÄISCHE PATENTSCHRIFT

(11) **EP 2 815 190 B1**
(45) Veröffentlichungstag und Bekanntmachung des Hinweises auf die Patenterteilung: **27.04.2016**
(21) Anmeldenummer: 13702206.7
(22) Anmeldetag: 24.01.2013
(51) Int. Cl.: F24J 2/52

(54) **HALTER FÜR EIN SOLARMODUL**
HOLDER FOR A SOLAR PANEL
DISPOSITIF DE RETENUE POUR UN MODULE SOLAIRE

(30) Priorität: 13.02.2012 DE 202012001369 U; 03.05.2012 DE 202012004333 U; 21.05.2012 DE 102012208480
(43) Veröffentlichungstag der Anmeldung: 24.12.2014
(73) Patentinhaber: Ilzhöfer, Werner, 97437 Haßfurt (DE)
(72) Erfinder: Ilzhöfer, Werner, 97437 Haßfurt (DE)
(74) Vertreter: Gassner, Wolfgang
(86) Internationale Anmeldenummer: PCT/EP2013/051373
(87) Internationale Veröffentlichungsnummer: WO 2013/120677

(56) Entgegenhaltungen:
- EP-A1- 2 012 365
- EP-A2- 1 070 923
- EP-A2- 2 402 679
- WO-A1-2011/054943
- WO-A2-2012/014203
- DE-B3-102010 022 556
- DE-U1-202007 006 094
- DE-U1-202007 008 471
- DE-U1-202008 000 997
- DE-U1-202009 003 124
- DE-U1-202009 007 526
- DE-U1-202009 016 197
- DE-U1-202011 108 873
- JP-A- 2003 035 016
- US-A1- 2007 144 575

## Beschreibung

Die Erfindung betrifft einen Halter für ein Solarmodul nach dem Oberbegriff des Anspruchs 1.

Ein solcher Halter ist aus der WO 2011/054943 A1 bekannt. Der bekannte Halter ist an die Rahmengeometrie des jeweils verwendeten Solarmoduls ange-passt.

Wegen der Vielzahl unterschiedlicher Rahmengeometrien müssen eine Vielzahl dazu korrespondierender Halter hergestellt und vorgehalten werden. Das ist aufwändig, umständlich und teuer.

Ein weiterer Halter für ein Solarmodul ist aus der DE 10 2010 022 556 B3 bekannt, wobei der Halter Aufnahmeelemente aufweist, wobei jedem Aufnahmeelement zumindest eine an der Grundplatte angebrachte, in ihrem Abstand zum Aufnahmeelement veränderbare Stützfläche zum Abstützen der Seitenwand zugeordnet ist. Das Aufnahmeelement weist einen Schlitz zum Einschieben des Schenkels auf.

Aufgabe der Erfindung ist es, die Nachteile nach dem Stand der Technik zu beseitigen. Es soll insbesondere ein Halter angegeben werden, der zur Aufnahme einer Vielzahl unterschiedlicher Rahmengeometrien von Solarmodulen geeignet ist. Nach einem weiteren Ziel der Erfindung soll der Halter möglichst einfach und kostengünstig herstellbar sein. Ferner soll eine möglichst schnelle und einfache Montage des Solarmoduls am Halter möglich sein.

Diese Aufgabe wird durch die Merkmale der Ansprüche 1 und 10 gelöst. Zweckmäßige Ausgestaltungen der Erfindung ergeben sich aus den Merkmalen der Ansprüche 2 bis 9, 11 und 12.

Nach Maßgabe der Erfindung wird vorgeschlagen, dass eine veränderbare Stützfläche durch eine Mehrzahl an Zungen gebildet ist, deren Abstand zu einem Ende eines Schlitzes unterschiedlich ist.

Der Schlitz ist durch zwei Ufer begrenzt. Das eine Ufer des Schlitzes ist zweckmäßigerweise in einem Winkel von 10° bis 40°, vorzugsweise von 15° bis 25°, zur Grundplatte hin geneigt. Die Neigung des einen Ufers des Schlitzes entspricht im Wesentlichen der gewünschten Neigung des unter Verwendung des erfindungsgemäßen Halters aufzuständernden Solarmoduls. Das andere Ufer des Schlitzes verläuft zweckmäßigerweise nicht parallel zum einen Ufer. Es kann etwa parallel zur Grundplatte verlaufen, so dass sich der Schlitz V-förmig öffnet. Das ermöglicht es, den Schenkel des Rahmens etwa parallel zur Grundplatte in den Schlitz einzuführen und nachfolgend so zu verschwenken, dass er am einen Ufer im Wesentlichen anliegt. Damit wird gleichzeitig eine Seitenwand des Rahmens so verschwenkt, dass sie in den Bereich der Stützfläche gelangt und dort abgestützt wird. Damit wird das Solarmodul im verschwenkten Zustand also sicher und zuverlässig im Halter gehalten. Die Fixierung des Solarmoduls. durch einfaches Einstecken und nachfolgendes Verschwenken lässt sich einfach und schnell durchführen. Es sind dazu insbesondere keine Befestigungsmittel erforderlich.

Nach einer weiteren besonders vorteilhaften Ausgestaltung der Erfindung erstreckt sich vom einen Ufer zumindest ein spitzer Vorsprung in Richtung des gegenüberliegenden anderen Ufers. Vorteilhafterweise erstrecken sich mehrere spitze Vorsprünge in Richtung des gegenüberliegenden anderen Ufers. Die vorgeschlagenen spitzen Vorsprünge dienen dazu, eine ggf. am Schenkel vorgesehene Farb- oder Eloxalschicht oder sonstige Schicht zu durchbohren, so dass zwischen dem Halter und den Rahmen ein elektrischer Kontakt hergestellt wird. Das ermöglicht eine Ableitung unerwünschter statischer Aufladungen vom Rahmen über den Halter an die Erde.

Nach einer weiteren vorteilhaften Ausgestaltung kann zwischen den Aufnahmeelementen ein von der Grundplatte sich erstreckender Stützsteg vorgesehen sein. Zweckmäßigerweise korrespondiert eine Höhe des Stützstegs zum Abstand des dazu benachbarten einen Ufers von der Grundplatte. D. h. durch das Vorsehen eines derartig ausgestalteten Stützstegs wird der Schenkel nicht nur über die einen Ufer der Aufnahmeelemente, sondern zusätzlich auch durch den dazwischen sich erstreckenden Stützsteg abgestützt. Damit wird ein verbesserter Lastabtrag vom Solarmodul auf den Halter erreicht. Der vorgeschlagene Halter ermöglicht also eine besonders haltbare Aufnahme des Rahmens.

Zweckmäßigerweise erstrecken sich die Zungen von der Grundplatte schräg in Richtung einer durch die Schlitze gebildeten Öffnungsebene. Die Zungen können in eine dazu korrespondierende Zungenausnehmung in der Grundplatte zurückbiegbar sein. Damit ist es möglich, den Rahmen des Solarmoduls zunächst so in die durch die Aufnahmeelemente gebildeten Schlitze einzustecken, dass der Schenkel etwa parallel zur Grundplatte ausgerichtet ist. Durch ein Verschwenken des Schenkels in Richtung des einen Ufers des Schlitzes werden dann diejenigen Zungen in die Zungenausnehmungen zurückgedrückt, welche sich bis unter den Schenkel des Rahmens erstrecken. Die längste Zunge derjenigen Zungen, welche nicht in die Grundplatte zurückgebogen wird, bildet die Stützfläche zum Abstützen der nach dem Verschwenken des Rahmens gegenüberliegenden Seitenwand.

Nach einer weiteren Ausgestaltung der Erfindung erstreckt sich von der Grundplatte jeweils gegenüberliegend zu dem Aufnahmeelement ein fester Anschlag. Sofern die als Stützflächen wirkenden Zungen unerwarteterweise infolge der Ausübung einer hohen Last brechen oder knicken, dient der feste Anschlag als weitere Stützfläche. Der Halter ist also hinsichtlich der Befestigung des Solarmoduls redundant und damit besonders sicher ausgebildet. Selbst bei einem Ausfall der beispielsweise als Zungen ausgebildeten Stützfläche kann durch den vorgeschlagenen festen Anschlag ein Abheben, beispielsweise durch Windkräfte, des Solarmoduls vom Halter vermieden werden.

Zweckmäßigerweise ist der Halter aus einem Stück aus Blech, insbesondere aus einem Aluminium- oder einem Edelstahl-Blech, hergestellt. Der Halter kann insbesondere mittels Laserschneiden und Kanten aus einem Teil hergestellt sein.

Nach weiterer Maßgabe der Erfindung wird eine Stützvorrichtung für ein Solarmodul vorgeschlagen, wobei zumindest ein erfindungsgemäßer Halter mit seiner Grundplatte auf einer Profilschiene angebracht ist. Bei der Profilschiene kann es sich beispielsweise um ein Vierkantrohr handeln.

Zweckmäßigerweise ist in einem vorgegebenen Abstand zum Halter ein Stützelement zum Abstützen des Solarmoduls an einer der einen Seite des Rahmens gegenüberliegenden anderen Seite vorgesehen. Das Stützelement kann beispielsweise verschwenkbar an der Profilschiene oder auch am Rahmen des Solarmoduls angebracht sein. Unter Verwendung zweier nebeneinanderliegender derartiger Stützvorrichtungen ist es möglich, das Solarmodul in die Halter einzuhängen, zu verschwenken und nachfolgend mittels des Stützelements an der anderen Seite des Rahmens schräg abzustützen. Das Stützelement ist zweckmäßigerweise so ausgebildet, dass damit das im Halteelement gehaltene Solarmodul bezüglich der Profilschiene in einem Winkel von 10° bis 40°, vorzugsweise 15° bis 25°, aufstellbar ist.

Nach einer besonders vorteilhaften Ausgestaltung der Erfindung sind auf einer Profilschiene abwechselnd mehrere erfindungsgemäße Halter sowie mehrere, beispielsweise schwenkbar gehaltene, Stützelemente angebracht. Unter Verwendung derartiger Stützvorrichtungen ist es möglich, hintereinander mehrere Solarmodule schräg aufzuständern. Derartige Stützvorrichtungen eignen sich insbesondere zum Aufständern von Solarmodulen auf Flachdächern.

Nachfolgend werden Ausführungsbeispiele der Erfindung anhand der Zeichnungen näher erläutert. Es zeigen:
- Fig. 1: eine perspektivische Ansicht eines auf einer Stützvorrichtung aufgeständerten Rahmens eines Solarmoduls,
- Fig. 2: eine perspektivische Ansicht einer Stützeinrichtung gemäß Fig. 1,
- Fig. 3: eine perspektivische Ansicht eines Halters und
- Fig. 4: eine Draufsicht auf eine Ausgestaltung der Stütze.

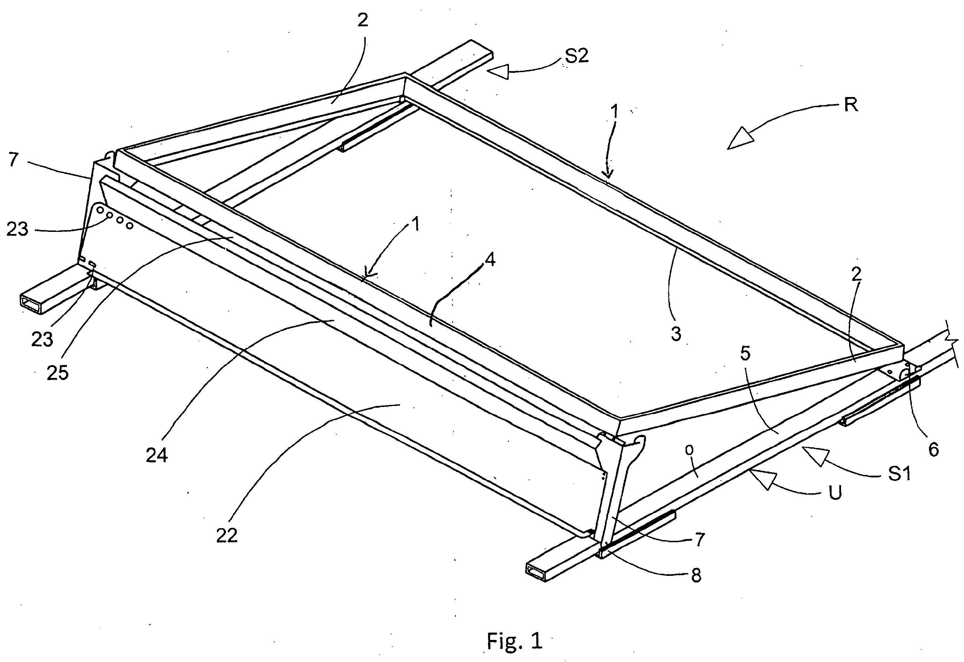

In Fig. 1 ist der Übersichtlichkeit halber hier lediglich ein rechteckiger Rahmen R eines Solarmoduls (hier nicht gezeigt) dargestellt. Der Rahmen R weist zwei einander gegenüberliegende erste Streben 1 sowie zwei einander gegenüberliegende zweite Streben 2 auf. Die zweiten Streben 2 sind kürzer ausgebildet als die ersten Streben 1. Die Streben 1, 2 sind jeweils nach Art eines U-Profils ausgebildet, wobei ein freier Schenkel 3 zu einem vom Rahmen R umschlossenen Rahmeninneren hin weist. Eine umlaufende Seitenwand des Rahmens R ist mit dem Bezugszeichen 4 bezeichnet.

Mit dem Bezugszeichen S1 und S2 sind Stützvorrichtungen bezeichnet. Jede der Stützvorrichtungen S1, S2 weist eine Profilschiene 5 auf, die beispielsweise aus einem Vierkantrohr gebildet ist. Auf einer oberen Seite O der Profilschiene 5 ist ein Halter 6 montiert. In einem vorgegebenen Abstand vom Halter 6 ist eine Stütze 7 schwenkbar an der Profilschiene 5 angebracht. Mit dem Bezugszeichen 8 sind Elastomerelemente bezeichnet, welche an einer Unterseite U der Profilschiene 5 angebracht und beispielsweise mittels eines Klebstoffs befestigt sind.

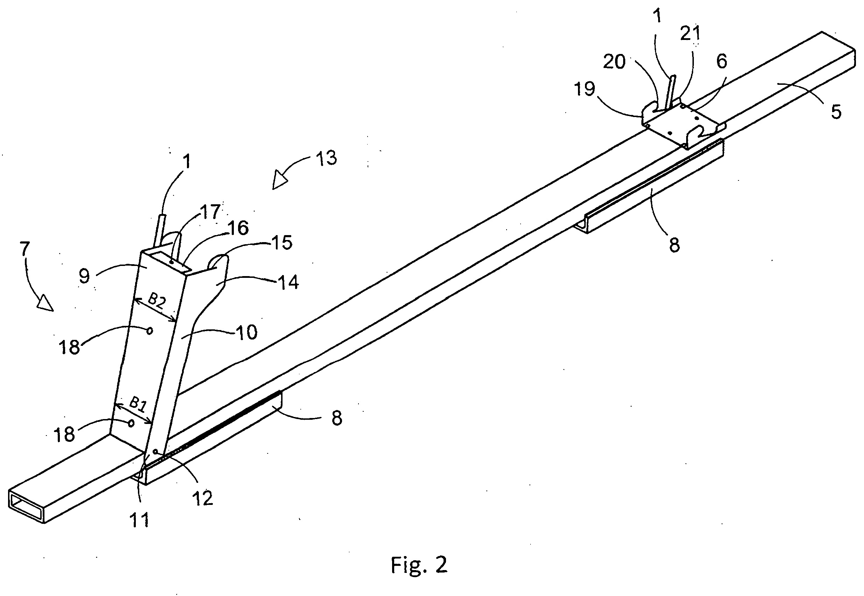

Wie insbesondere aus Fig. 2 hervorgeht, ist die Stütze 7 nach Art eines U-Profils ausgebildet. Sie weist einen Profilgrundabschnitt 9 und zwei davon sich erstreckende einander gegenüberliegende Schenkel 10 auf. Von den Schenkeln 10 erstrecken sich jeweils Schwenkbefestigungsabschnitte 11, welche einen ersten Durchbruch 12 aufweisen, durch die Befestigungsmittel (hier nicht gezeigt) geführt sind, so dass die Stütze 7 schwenkbar an der Profilschiene 5 gehalten ist. Eine erste Breite B1 des Profilgrundabschnitts 9 in der Nähe der Schwenkbefestigungsabschnitte 11 ist kleiner als eine zweite Breite B2 in der Nähe eines freien Endes der Stütze 7. Der Profilgrundabschnitt 9 weist also eine trapezartige Form auf. Ein am freien Ende der Stütze 7 vorgesehenes Befestigungselement 13 umfasst Befestigungsabschnitte 14, welche sich von den Schenkeln 10 erstrecken. Jeder der Befestigungsabschnitte 14 weist einen Schlitz 15 auf, welcher sich zum Profilgrundabschnitt 9 hin öffnet. Am freien Ende des Profilgrundabschnitts 9 ist außerdem ein Sicherungsabschnitt 16 vorgesehen, welcher durch eine um etwa 90° vom Profilgrundabschnitt 9 umgebogene Lasche gebildet ist. Der Sicherungsabschnitt 16 weist einen zweiten Durchbruch 17 auf. Mit dem Bezugszeichen 18 sind dritte Durchbrüche bezeichnet, welche im Profilgrundabschnitt 9 vorgesehen sind.

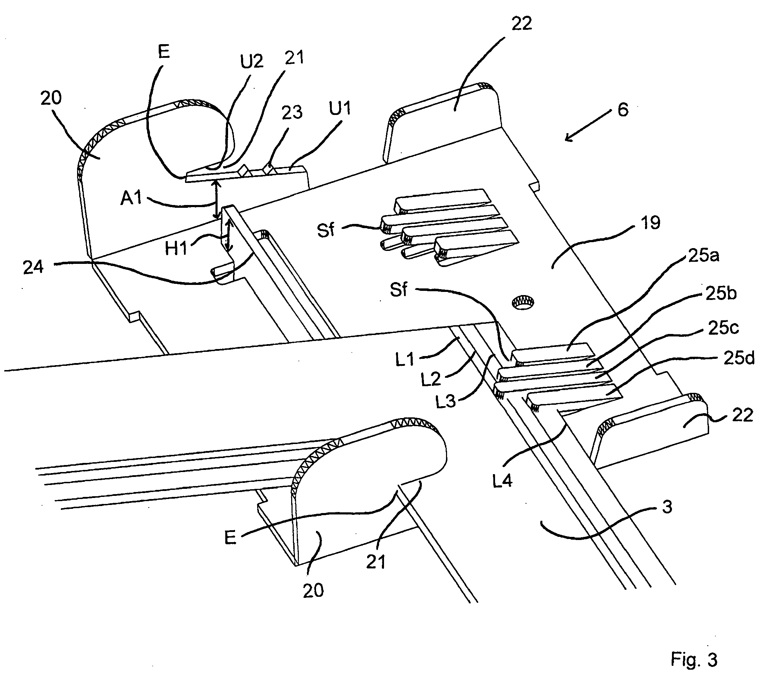

Der insbesondere auch in Fig. 3 gezeigte Halter 6 weist eine Grundplatte 19 auf, von der sich Aufnahmeelemente 20 mit jeweils einem weiteren Schlitz 21 erstrecken. Der Halter 6 ist bezüglich der Stütze 7 so auf der Oberseite O der Profilschiene 5 montiert, dass sich der weitere Schlitz 21 bezüglich des Schlitzes 15 in eine entgegengesetzte Richtung öffnet. Gegenüberliegend einer Öffnung des weiteren Schlitzes 21 ist jeweils ein fester Anschlag 22 vorgesehen. Mit dem Bezugszeichen 3 ist hier lediglich der Schenkel des (sonst nicht näher dargestellten) Rahmens R gezeigt.

Das eine Ufer U1 des weiteren Schlitzes 21 bildet hier mit der Grundplatte 19 etwa einen Winkel von 20°. Vom einen Ufer U1 erstrecken sich in Richtung des gegenüberliegenden anderen Ufers U2 spitze Vorsprünge 23. Die spitzen Vorsprünge 23 sind zweckmäßigerweise gehärtet. Die Härtung kann durch Herstellung der spitzen Vorsprünge 23 mittels Laserschneiden und deren nachfolgende rasche Abkühlung erreicht werden. Zwischen den Aufnahmeelementen 20 ist ein von der Grundplatte 19 sich erstreckender Stützsteg 24 vorgesehen. Eine mit dem Bezugszeichen H1 bezeichnete Höhe des Stützstegs 24 korrespondiert zum Abstand A1 des dazu benachbarten einen Ufers U1 von der Grundplatte 19.

Von der Grundplatte 19 erstrecken sich schräg in Richtung einer durch die weiteren Schlitze 21 bzw. den darin eingesteckten Schenkel 3 gebildete Öffnungsebene Zungen 25a, 25b, 25c sowie 25d. Die Zungen 25a-25d unterscheiden sich in ihrer Länge und damit in ihrem Abstand zum einen Ende E des weiteren Schlitzes 21.

Mit L1, L2, L3 und L4 sind unterschiedliche Rahmengeometrien angedeutet. D. h. der Schenkel 3 kann entsprechend den Linien L1, L2, L3, L4 unterschiedliche Tiefen aufweisen. Im Falle der Tiefe L1 erstreckt sich vom Schenkel 3 im Bereich der Linie L1 die Seitenwand 4. Im Falle der Tiefe L1 würde die (hier nicht gezeigte) Seitenwand 4 also durch die durch die Zunge 25c gebildete Stützfläche Sf abgestützt. Im Falle eines Schenkels 3 mit der Tiefe L2 würde eine davon sich ersteckende Seitenwand 4 durch die durch die Zunge 25b gebildete Stützfläche Sf abgestützt. Im Falle eines Schenkels 3 mit der Tiefe L4 dient als Stützfläche der feste Anschlag 22.

Zur Montage des Solarmoduls im Halter 6 wird zunächst der Schenkel 3 des Rahmens R in etwa paralleler Ausrichtung zur Grundplatte 19 in den weiteren Schlitz 21 bis zum Anliegen an dessen Ende E eingesteckt. Sodann wird der Schenkel 3 so verschwenkt, dass er etwa auf dem einen Ufer U1 zum Liegen kommt. Dabei Durchdringen die spitzen Vorsprünge 23 eine am Schenkel 3 vorgesehene Eloxal- oder Farbschicht. Gleichzeitig werden je nach Tiefe L1-L4 des Schenkels 3 die unter dem Schenkel 3 befindlichen Zungen 25a-25d in Richtung der Grundplatte 19 zurückgebogen. Die längste derjenigen Zungen 25a-25d, welche sich beim Verschwenken des Schenkels 3 nicht unter diesem befinden, verbleiben in ihrer schräg nach oben gebogenen Position und bilden somit eine Stützfläche Sf zum Abstützen der sich vom Schenkel 3 erstreckenden Seitenwand 4 (hier nicht gezeigt).

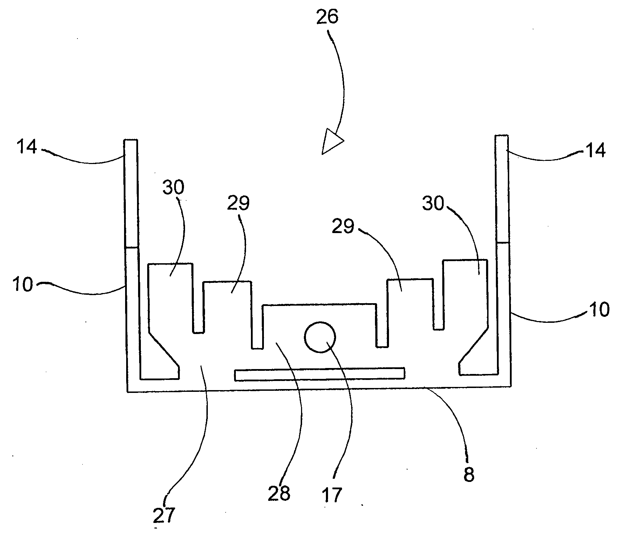

Fig. 4 zeigt eine Draufsicht auf eine weitere Stütze 26. Die weitere Stütze 26 weist einen weiteren Sicherungsabschnitt 27 auf. Der weitere Sicherungsabschnitt 27 wiederum ist im Wesentlichen symmetrisch ausgebildet und weist eine erste Zunge 28 auf, welche mit dem zweiten Durchbruch 17 versehen ist. Beidseits der ersten Zungen 28 sind zweite Zungen 29 und beidseits der zweiten Zungen 29 dritte Zungen 30 vorgesehen. Die ersten 28, die zweiten 29 und die dritten Zungen 30 sind jeweils durch Einschnitte voneinander getrennt. Die ersten Zungen 28 erstrecken sich mit einer weiten ersten Tiefe in Richtung des Befestigungsabschnitts 14, die zweiten Zungen 29 erstrecken sich mit einer weiteren zweiten Tiefe L2 in Richtung des Befestigungsabschnitts 14 und die dritten Zungen 30 erstrecken sich mit einer dritten Tiefe L3 in Richtung des Befestigungsabschnitts 14. Die erste Tiefe L1 ist kleiner als die zweite Tiefe L2; die zweite Tiefe L2 ist kleiner als die dritte Tiefe L3. Mit der vorgeschlagenen Ausgestaltung des weiteren Sicherungsabschnitts 27 ist es möglich, mittels der weiteren Stütze 26 unterschiedlich ausgestaltete Rahmengeometrien zu befestigen. Durch Einstecken eines Werkzeugs in den zweiten Durchbruch 17 kann beispielsweise ein Rahmen R gesichert werden, dessen Schenkel 3 sich beispielsweise über die dritten Zungen 30 erstreckt. In diesem Fall kann ein solcher Rahmen R durch Hochbiegen der ersten 28 sowie der zweiten Zungen 29 gesichert werden. Die vorgeschlagene weitere Stütze 26 eignet sich also universell zur Befestigung einer Vielzahl von am Markt befindlichen Solarmodulen.

Der Halter 6 sowie die Stütze 7 sind vorteilhaferweise aus mittels Laserschneiden hergestellten Blechen gebildet, welche nachfolgend gekantet sind. Sowohl der Halter 6 als auch die Stütze 7 sind zweckmäßigerweise aus einem Stück gefertigt.

Wie insbesondere aus Fig. 1 ersichtlich ist, dienen der Halter 6 sowie die Stütze 7 jeweils der Abstützung zweier benachbarter Solarmodule. Das macht die Stützvorrichtung S1, S2 besonders effizient. Sie ermöglichen ein Aufständern einer Vielzahl von Solarmodulen mit einem geringen Montage- und Herstellungsaufwand.

Obwohl es in den Figuren nicht gezeigt ist, können auf einer Profilschiene 5 mehrere Halter 6 sowie Stützen 7 abwechselnd montiert sein. D. h. eine Stützvorrichtung S1, S2 kann in diesem Fall zum Abstützen mehrerer Solarmodule hintereinander verwendet werden, was die Effizienz der Vorrichtung weiter verbessert.

### Bezugszeichenliste

- 1: erste Strebe
- 2: zweite Strebe
- 3: freier Schenkel
- 4: Seitenwand
- 5: Profilschiene
- 6: Halter
- 7: Stütze
- 8: Elastomerelement
- 9: Profilgrundabschnitt
- 10: Schenkel
- 11: Schwenkbefestigungsabschnitt
- 12: erster Durchbruch
- 13: Befestigungselement
- 14: Befestigungsabschnitt
- 15: Schlitz
- 16: Sicherungsabschnitt
- 17: zweiter Durchbruch
- 18: dritter Durchbruch
- 19: Grundplatte
- 20: Aufnahmeelement
- 21: weiterer Schlitz
- 22: fester Anschlag
- 23: spitzer Vorsprung
- 24: Stützsteg
- 25a-25d: Zungen
- 26: weitere Stütze
- 27: weiterer Sicherungsabschnitt
- 28: erste Zunge
- 29: zweite Zunge
- 30: dritte Zunge
- A1: Abstand
- B1: erste Breite
- B2: zweite Breite
- E: Ende
- H1: Höhe
- L1: erste Tiefe
- L2: zweite Tiefe
- L3: dritte Tiefe
- L4: vierte Tiefe
- O: Oberseite
- R: Rahmen
- S1: erste Stützvorrichtung
- S2: zweite Stützvorrichtung
- Sf: Stützfläche
- U: Unterseite
- U1: eines Ufer
- U2: zweites Ufer

## Patentansprüche

1. Halter (6) für ein Solarmodul mit einem rechteckigen Rahmen (R), welcher eine umlaufende Seitenwand (4) aufweist, von der sich an zumindest einer Seite ein zum Rahmeninneren hin weisender Schenkel (3) erstreckt,
wobei der Halter (6) eine Grundplatte (19) mit zwei davon sich erstreckenden Aufnahmeelementen (20) zur Aufnahme des Schenkels (3) aufweist,
wobei jedem Aufnahmeelement (20) zumindest eine an der Grundplatte (19) angebrachte, in ihrem Abstand zum Aufnahmeelement (20) veränderbare Stützfläche (Sf) zum Abstützen der Seitenwand (4) zugeordnet ist,
wobei die Aufnahmeelemente (20) jeweils einen Schlitz (21) zum Einschieben des Schenkels (3) aufweisen,
**dadurch gekennzeichnet, dass**
die veränderbare Stützfläche (Sf) durch eine Mehrzahl an Zungen (25a-25d) gebildet ist, deren Abstand zu einem Ende (E) des Schlitzes (21) unterschiedlich ist.

2. Halter (6) nach Anspruch 1, wobei das eine Ufer (U1) des Schlitzes (21) in einem Winkel von 10° bis 40°, vorzugsweise 15° bis 25°, zur Grundplatte (19) hin geneigt ist.

3. Halter (6) nach einem der vorhergehenden Ansprüche, wobei sich vom einen Ufer (U1) des Schlitzes (21) zumindest ein spitzer Vorsprung (23) in Richtung des gegenüberliegenden anderen Ufers (U2) erstreckt.

4. Halter (6) nach einem der vorhergehenden Ansprüche, wobei zwischen den Aufnahmeelementen (20) ein von der Grundplatte (19) sich erstreckender Stützsteg (24) vorgesehen ist.

5. Halter (6) nach Anspruch 4, wobei eine Höhe (H1) des Stützstegs (24) zum Abstand (A1) des dazu benachbarten einen Ufers (U1) des Schlitzes (21) von der Grundplatte (19) korrespondiert.

6. Halter (6) nach einem der vorhergehenden Ansprüche, wobei sich die Zungen (25a-25d) von der Grundplatte (19) schräg in Richtung einer durch die Schlitze (21) gebildeten Öffnungsebene erstrecken.

7. Halter (6) nach einem der vorhergehenden Ansprüche, wobei die Zungen (25a-25d) in eine dazu korrespondierende Zungenausnehmung in der Grundplatte (19) zurück biegbar sind.

8. Halter (6) nach einem der vorhergehenden Ansprüche, wobei sich von der Grundplatte (19) jeweils gegenüberliegend zu den Aufnahmeelementen (20) ein fester Anschlag (22) erstreckt.

9. Halter (6) nach einem der vorhergehenden Ansprüche, wobei der Halter (6) aus einem Stück aus einem Blech, insbesondere einem Aluminium- oder Edelstahlblech, hergestellt ist.

10. Stützvorrichtung (S1, S2) für ein Solarmodul, wobei zumindest ein Halter (6) nach einem der vorhergehenden Ansprüche mit seiner Grundplatte (19) auf einer Profilschiene (5) angebracht ist.

11. Stützvorrichtung (S1, S2) nach Anspruch 10, wobei in einem vorgegeben Abstand vom Halter (6) ein Stützelement (7) zum Abstützen des Solarmoduls an einer der einen Seite des Rahmens (R) gegenüberliegenden anderen Seite vorgesehen ist.

12. Stützvorrichtung (S1, S2) nach Anspruch 10 oder 11, wobei das Stützelement (7) so ausgebildet ist, dass damit das im Halter (6) gehaltene Solarmodul bezüglich der Profilschiene (5) in einem Winkel von 10° bis 40°, vorzugsweise von 15° bis 25°, aufstellbar ist.

## Claims

1. A holder (6) for a solar module having a rectangular frame (R) which has a peripheral side wall (4) from at least one side of which there extends a leg (3) that is directed toward the frame interior,
wherein the holder (6) has a base plate (19) with two receiving elements (20) extending therefrom for receiving the leg (3),
wherein each receiving element (20) is assigned at least one support surface (Sf), attached to the base plate (19), for supporting the side wall (4), the spacing of said support surface (Sf) from the receiving element (20) being variable,
wherein the receiving elements (20), each have a slot (21) for introducing the leg (3),
**characterized in that**
the variable support surface (Sf) is formed by a plurality of tongues (25a-25d) which are at different spacings from one end (E) of the slot (21).

2. The holder (6) as claimed in claim 1, wherein the one face (U1) of the slot (21) is inclined at an angle of 10° to 40°, preferably 15° to 25°, to the base plate (19).

3. The holder (6) as claimed in either of the preceding claims, wherein at least one pointed protrusion (23) extends from the one face (U1) of the slot (21) in the direction of the opposing other face (U2).

4. The holder (6) as claimed in one of the preceding claims, wherein a support bar (24) that extends from the base plate (19) is provided between the receiving elements (20).

5. The holder (6) as claimed in claim 4, wherein a height (H1) of the support bar (24) corresponds to the spacing (A1) of the one face (U1) of the slot (21) adjacent thereto from the base plate (19).

6. The holder (6) as claimed in one of the preceding claims, wherein the tongues (25a-25d) extend obliquely from the base plate (19) in the direction of an opening plane formed by the slots (21).

7. The holder (6) as claimed in one of the preceding claims, wherein the tongues (25a-25d) are bendable back into a tongue recess, corresponding thereto, in the base plate (19).

8. The holder (6) as claimed in one of the preceding claims, wherein a fixed stop (22) extends from the base plate (19) in each case opposite the receiving elements (20).

9. The holder (6) as claimed in one of the preceding claims, wherein the holder (6) is produced in one piece from a metal sheet, in particular an aluminum or stainless steel sheet.

10. A support device (S1, S2) for a solar module, wherein at least one holder (6) as claimed in one of the preceding claims is attached by way of its base plate (19) to a profile rail (5).

11. The support device (S1, S2) as claimed in claim 10, wherein a support element (7) for supporting the solar module on another side opposite the one side of the frame (R) is provided at a predetermined spacing from the holder (6).

12. The support device (S1, S2) as claimed in claim 10 or 11, wherein the support element (7) is configured such that the solar module held in the holder (6) is settable at an angle of 10° to 40°, preferably 15° to 25°, with respect to the profile rail (5) by way of said support element (7).

## Revendications

1. Dispositif de retenue (6) pour un module solaire pourvu d'un cadre rectangulaire (R) qui comporte une paroi latérale périphérique (4) à partir de laquelle s'étend sur au moins une face un côté (3) orienté vers l'intérieur du cadre, en ce que le dispositif de retenue (6) comporte une plaque de base (19) à partir de laquelle s'étendent deux éléments récepteurs (20) destinés à recevoir le côté (3), en ce que chaque élément récepteur (20) est associé à au moins une surface d'appui (Sf) destinée à supporter la paroi latérale (4), située sur la plaque de base (19) et dont l'écart par rapport à l'élément récepteur (20) peut être modifié,
en ce que les éléments récepteurs (20) comportent respectivement une rainure (21) destinée à insérer le côté (3),
**caractérisé en ce que**
la surface d'appui (Sf) variable est formée par une pluralité de languettes (25a-25d) dont l'écart par rapport à une extrémité (E) de la rainure (21) est différent.

2. Dispositif de retenue (6) selon la revendication 1, en ce que l'un des bords (U1) de la rainure (21) est incliné vers la plaque de base (19) à un angle de 10 à 40°, de préférence de 15 à 25°.

3. Dispositif de retenue (6) selon l'une des revendications précédentes, en ce qu'au moins une saillie pointue (23) s'étend à partir d'un bord (U1) de la rainure (21) vers l'autre bord (U2) opposé.

4. Dispositif de retenue (6) selon l'une des revendications précédentes, en ce qu'une traverse support (24) s'étendant à partir de la plaque de base (19) est prévue entre les éléments récepteurs (20).

5. Dispositif de retenue (6) selon la revendication 4, en ce qu'une hauteur (H1) de la traverse support (24) correspond à l'écart (A1) de l'un des bords (U1) de la rainure (21) de la plaque de base (19) qui y est adjacent.

6. Dispositif de retenue (6) selon l'une des revendications précédentes, en ce que les languettes (25a-25d) s'étendent de manière inclinée à partir de la plaque de base (19) vers un plan d'ouverture formée par les rainures (21).

7. Dispositif de retenue (6) selon l'une des revendications précédentes, en ce que les languettes (25a-25d) peuvent être recourbées dans un évidement de languette correspondant dans la plaque de base (19).

8. Dispositif de retenue (6) selon l'une des revendications précédentes, en ce qu'une butée fixe (22) respectivement opposée aux éléments récepteurs (20) s'étend à partir de la plaque de base (19).

9. Dispositif de retenue (6) selon l'une des revendications précédentes, en ce que le dispositif de retenue (6) est en une pièce, réalisé en tôle, en particulier en une tôle d'aluminium ou d'acier inoxydable.

10. Dispositif de support (S1, S2) pour un module solaire, en ce qu'au moins un dispositif de retenue (6) selon l'une des revendications précédentes est monté avec sa plaque de base (19) sur un rail profilé (5).

11. Dispositif de support (S1, S2) selon la revendication 10, en ce que, à un écart prédéfini du dispositif de retenue (6), un élément de support (7) est prévu pour le support du module solaire sur une autre face opposée à l'une des faces du cadre (R).

12. Dispositif de support (S1, S2) selon la revendication 10 ou 11, en ce que l'élément de support (7) est réalisé de manière à ce que le rail profilé (5) du module solaire retenu dans le dispositif de retenue (6) puisse être installé à un angle de 10 à 40°, de préférence de 15 à 25°.
